# EUROPEAN PATENT APPLICATION

(11) **EP 3 975 276 A1**
(43) Date of publication of application: **30.03.2022**
(21) Application number: 21193106.8
(22) Date of filing: 25.08.2021
(51) Int. Cl.: H01L 49/02, H01L 27/06, H01L 27/08

(54) **THIN FILM RESISTOR INCLUDING INDIUM AND OXYGEN FOR INTEGRATED CIRCUITS**

(30) Priority: 25.09.2020 US 202017033240
(71) Applicant: INTEL Corporation, Santa Clara, CA 95054 (US)
(72) Inventor: SELL, Bernhard, Portland, 97229 (US); WANG, Pei-Hua, Hillsboro, 97124 (US); KU, Chieh-Jen, Hillsboro, 97124 (US)
(74) Representative: HGF

(57) **Abstract**

Tunable resistance thin film resistors for integrated circuits, related systems, and methods of fabrication are disclosed. Such tunable resistance thin film resistors include electrodes coupled to a resistive thin film that includes a base metal oxide and a second metal element. The resistors are tunable based on the concentration of the second metal element in the composition of the resistive thin film.

## Description

### BACKGROUND

In integrated circuits (ICs), including analog ICs, resistors are important components for voltage regulation, employment of radio frequency (RF) components, and other uses. Currently, thin film resistors may be implemented in such contexts. However, given a fixed film thickness and current material systems, the variation in available sheet resistance is only about 50%. Therefore, in deployment, the width and or length of such thin film resistors is typically varied to attain the desired resistance between the electrodes of the resistor. Although the thickness of the thin film resistor can be varied to tune the resistor, such thickness variation causes other problems including complexity in subsequent processing, in particular, dry etch and planarization integration processing.

It is desirable to have the capability to adjust or tune film resistance to provide design flexibility for thin film resistors in ICs such as analog ICs applications, nanoscale quantum circuit applications, and others. It is with respect to these and other considerations that the present improvements have been needed. Such improvements may become critical as the desire to implement thin film resistors becomes more widespread.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements. In the figures:
FIG. 1 is a cross-sectional view of an integrated circuit structure including a thin film resistor;
FIG. 2 is another cross-sectional view of the integrated circuit structure of FIG. 1;
FIG. 3 is a cross-sectional view of an integrated circuit structure including a thin film resistor and one or more additional thin film resistors at different levels within the integrated circuit structure;
FIG. 4 is a flow diagram illustrating methods for forming integrated circuit structures with thin film resistors;
FIGS. 5, 6, 7, 8, 9, 10, 11, and 12 are cross-sectional views of exemplary integrated circuit structures as selected fabrication operations in the methods of FIG. 4 are performed;
FIG. 13 is an illustrative diagram of a mobile computing platform employing a device having a thin film resistor; and
FIG. 14 is a functional block diagram of a computing device, all arranged in accordance with at least some implementations of the present disclosure.

### DETAILED DESCRIPTION

One or more embodiments or implementations are now described with reference to the enclosed figures. While specific configurations and arrangements are discussed, it should be understood that this is done for illustrative purposes only. Persons skilled in the relevant art will recognize that other configurations and arrangements may be employed without departing from the spirit and scope of the description. It will be apparent to those skilled in the relevant art that techniques and/or arrangements described herein may also be employed in a variety of other systems and applications other than what is described herein.

Reference is made in the following detailed description to the accompanying drawings, which form a part hereof, wherein like numerals may designate like parts throughout to indicate corresponding or analogous elements. It will be appreciated that for simplicity and/or clarity of illustration, elements illustrated in the figures have not necessarily been drawn to scale. For example, the dimensions of some of the elements may be exaggerated relative to other elements for clarity. Further, it is to be understood that other embodiments may be utilized and structural and/or logical changes may be made without departing from the scope of claimed subject matter. It should also be noted that directions and references, for example, up, down, top, bottom, over, under, and so on, may be used to facilitate the discussion of the drawings and embodiments and are not intended to restrict the application of claimed subject matter. Therefore, the following detailed description is not to be taken in a limiting sense and the scope of claimed subject matter defined by the appended claims and their equivalents.

In the following description, numerous details are set forth. However, it will be apparent to one skilled in the art, that the present invention may be practiced without these specific details. In some instances, well-known methods and devices are shown in block diagram form, rather than in detail, to avoid obscuring the present invention. Reference throughout this specification to "an embodiment" or "one embodiment" means that a particular feature, structure, function, or characteristic described in connection with the embodiment is included in at least one embodiment of the invention. Thus, the appearances of the phrase "in an embodiment" or "in one embodiment" in various places throughout this specification are not necessarily referring to the same embodiment of the invention. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description of the invention and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items.

The terms "coupled" and "connected," along with their derivatives, may be used herein to describe structural relationships between components. It should be understood that these terms are not intended as synonyms for each other. Rather, in particular embodiments, "connected" may be used to indicate that two or more elements are in direct physical or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause an effect relationship).

The terms "over," "under," "between," "on", and/or the like, as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer is in direct contact with that second layer. Similarly, unless explicitly stated otherwise, one feature disposed between two features may be in direct contact with the adjacent features or may have one or more intervening features. The term immediately adjacent indicates such features are in direction contact. Furthermore, the terms "substantially," "close," "approximately," "near," and "about," generally refer to being within +/- 10% of a target value. The term layer as used herein may include a single material or multiple materials. As used in throughout this description, and in the claims, a list of items joined by the term "at least one of' or "one or more of" can mean any combination of the listed terms. For example, the phrase "at least one of A, B or C" can mean A; B; C; A and B; A and C; B and C; or A, B and C.

Integrated circuit structures, device structures, apparatuses, computing platforms, and methods are described herein related to tunable resistance thin film resistors and, in particular, to thin film resistors metal oxide resistors.

As described above, it may be advantageous to adjust or tune film resistance in thin film transistor applications such that the resistance may be tuned without varying the thickness of the resistive thin film of the resistor. In some embodiments, a thin film resistor comprises a thin film resistive element including indium, oxygen, and a second metal element (e.g., in addition to the indium element). As used herein, the term metal element includes any element having a corresponding material is a good conductor of heat and electricity. Metal elements include most elements and are inclusive of alkali metals, alkaline earth metals, transition metals, post transition metals, lanthanides, and actinides. In some embodiments, the second metal element is one of aluminum, magnesium, or hafnium with aluminum being particularly advantageous, although any metal may be used. In some embodiments, the second metal element is one of silver, copper, gold, tungsten, zinc, cobalt, nickel, ruthenium, platinum, tin, gallium, lead, titanium, manganese, germanium, aluminum, magnesium, or hafnium.

As discussed, the thin film resistive element including indium, oxygen, and a second metal element. As used herein, the term resistive indicates a material having a sheet resistance between 20000 ohm/sq and 1000 ohm/sq or other resistivity measure between about 0.001 ohm·cm and 0.2 ohm·cm. The indium, oxygen, and a second metal element of the thin film resistive element may be incorporated as an alloy of such materials, which may be characterized as InₓO_{1-x-y}ME_{y} where ME is used to represent any metal element. The concentration (by percentage) of the second metal element may be any suitable amount. In some embodiments, the concentration is less than 30% (as greater than 30% will cause the film to be an insulator). In some embodiments, the concentration of indium and oxygen is approximately the same. For example, given y, the concentration of indium and oxygen may be (1-y)/2.

In some embodiments, a resistor including the thin film resistive element including indium, oxygen, and a second metal element is incorporated in an integrated circuit device such that the resistor is a back end resistor (e.g., formed at a high level metallization level of the integrated circuit device). Furthermore, the integrated circuit device may include another front end resistor inclusive of the same material system or a different material system. In some embodiments, the front end resistor includes a thin film resistive that is a metallic thin film. In some embodiments, the metallic thin film includes one of titanium nitride, tungsten, or tantalum nitride. Notably, a front end resistor may not require the same tuning as a back end resistor.

As discussed, the material systems discussed herein with respect to the thin film resistive element (i.e., indium, oxygen, and a second metal element) provides for wide variation in the resistance of the thin film resistive element based on selection of the second metal element and the concentration of the second metal element. Using aluminum as an example of the second metal element, the sheet resistance can be varied by 50x or more from use of almost no aluminum (e.g., 1%, 0.1% or less) to use of 30% aluminum. For example, for no aluminum (and using indium oxide only), a resistivity of about 1800 ohm/sq is attained and with 30% aluminum, a sheet resistance of about 14000 ohm/sq is attained. Furthermore, by varying the amount of aluminum from 0 to 30%, variable resistance is attained at the same thin film resistive element width, length, and, importantly, thickness. For example, given a process for producing an integrated circuit device inclusive of a resistor having a thin film resistive element, it is particularly advantageous to be able to vary or tune resistance without changing thickness of the thin film resistive element as such thickness variation negatively impacts process integration, particularly for etch and planarization operations. That is, the process flow may be optimized for a particular thickness and any variation causes difficulties in re-optimization or, in extreme cases, re-tooling.

As discussed herein, tunable resistance thin film resistors are provided via incorporation of different metal elements into an oxide based thin film such as an indium oxide based thin film. The process flow to form the oxide based thin film resistor is advantageously capable of varying resistance using the process flow and with the same film thickness. In some embodiments, the incorporation of second metal element is via film deposition. Notably, such techniques provide a wide range of resistances inclusive of high resistivity with low processing complexity. The oxide based thin film discussed herein has capability to modulate resistance via in-situ doping such that changes in resistance value from low resistance to high resistance may be attained. Furthermore, the thin film resistive element are advantageously thermally stable up to 400°C.

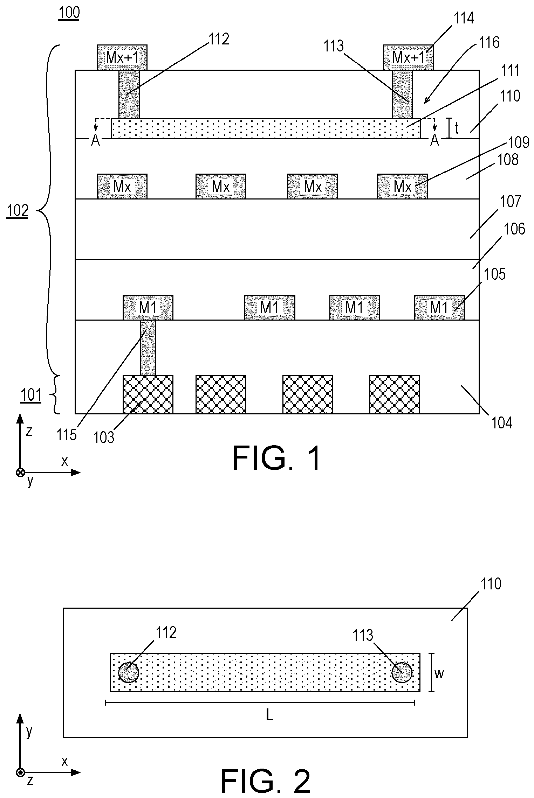

FIG. 1 is a cross-sectional view of an integrated circuit structure 100 including a thin film resistor 116 and FIG. 2 is another cross-sectional view of integrated circuit structure 100 including thin film resistor 116, arranged in accordance with at least some implementations of the present disclosure. As shown, FIG. 2 provides a view taken along the A-A plane in FIG. 1 in the negative z-direction. Integrated circuit structure 100 may also be characterized as a device structure or simply a device. As shown in FIG. 1, integrated circuit structure 100 includes a device layer 101 having any number of transistors 103 (illustrated simply as blocks in FIG. 1 or alternatively, the elements labeled 103 may be transistor gates) and metallization levels 102 having any number (e.g., x+1) of metallization levels 102 within dielectric layers or materials, which are labeled in FIG. 1 as inclusive of dielectric layers 106, 107, 108, 110 although any number of dielectric layers may be employed. Metallization levels 102 may include metal line levels and via levels therebetween to interconnect the metal line levels. For example, metallization levels 102 may include 5, 6, 7, or 8 metal line levels each interconnected by corresponding via levels.

As shown, metallization levels 102 are coupled to any number of transistors 103 by corresponding vias or contacts such as contact 115, which couples a metal line of metallization level 105 (e.g., metal 1, M1) to a gate of at least one of transistors 103. Similar contacts are provided between other metal lines and gates, sources, and drains of transistors 103 to form part of the circuitry of integrated circuit structure 100. Furthermore, metallization level 105 is interconnected to any number of intervening metallization levels through metallization level 109 (e.g., metal x, Mx), which is, in turn interconnected to metallization level 114 (e.g., metal x+1, Mx+1). Such interconnection, as discussed is provided by vias (not shown) and provides an additional part of the circuitry of integrated circuit structure 100.

Although illustrated with respect to device layer including only transistors 103, any types of devices may be employed. Furthermore, transistors 103 may be planar or non-planar and they may employ any suitable material system(s)s. Device layer 101 may be on or within a substrate such as a semiconductor substrate. For example, device layer 101 or the substrate may include any number and type of semiconductor devices formed within a semiconductor substrate material. In some examples, device layer 101 or the substrate includes a semiconductor material such as monocrystalline silicon (Si), germanium (Ge), silicon germanium (SiGe), a III-V materials based material (e.g., gallium arsenide (GaAs)), a silicon carbide (SiC), a sapphire (Al₂O₃), or any combination thereof. Semiconductor devices within device layer 101 may include transistors, memory devices, capacitors, resistors, optoelectronic devices, switches, or any other active or passive electronic devices.

As discussed, device layer 101 and metallization levels 102 are at least partially surrounded by dielectric material or dielectric layers such as dielectric layers 104, 106, 107, 108, 110. Dielectric layers 104, 106, 107, 108, 110 may include any combination of dielectric materials or a single dialectic material. Dielectric layers 104, 106, 107, 108, 110 provide electrical isolation between devices of device layer 101, metallization levels 102, vias, and so on. In some embodiments, dielectric layers 104, 106, 107, 108, 110 include alumina (Al₂O₃), silica (SiO), silicon nitrides (SiN), silicon oxynitrides (SiON), silicon carbonitrides (SiCN), or combinations thereof.

As discussed, integrated circuit structure 100 further includes thin film resistor 116. Although illustrated with a single thin film resistor 116 for the sake of clarity of presentation, any number of thin film resistors 116 may be included in integrated circuit structure 100. For example, each thin film resistor 116 may include the same resistive thin film 111 material system and thickness with any variation in length and width between the resistive thin film elements thereof.

As shown, thin film resistor 116 includes a resistive thin film 111 and electrodes 112, 113 or only resistive thin film 111. In some embodiments, electrodes 112, 113 are part of a via layer of metallization levels 102. In some embodiments, electrodes 112, 113, are vias independent of a via layer of metallization levels 102. Electrodes 112, 113 may include any suitable conductive or resistive material. In some embodiments, electrodes 112, 113 include one or more metals. In some embodiments, electrodes 112, 113 include copper or tungsten. As shown with respect to FIG. 2, in some embodiments, electrodes 112, 113 have a circular cross section. However, any suitable cross sectional shape may be employed.

Resistive thin film 111 (or thin film element) and the sheet resistance and resistance properties thereof largely define the resistance and performance characteristics of thin film resistor 116. Furthermore, the resistance and performance characteristics are based on the thickness, t, width, w, and length, L of thin film resistor 116. For example, the resistance of thin film resistor 116 may be proportional to the length of resistive thin film 111 and inversely proportional to the cross sectional area (i.e., wxt) of resistive thin film 111. The thickness, t, width, w, and length, L, of thin film resistor 116 may be any suitable values depending on application. In some embodiments, the thickness, t, of resistive thin film 111 is in the range of 5 to 15 nm. In some embodiments, the thickness, t, of resistive thin film 111 is in the range of 5 to 10 nm. In some embodiments, the thickness, t, of resistive thin film 111 is in the range of 6 to 8 nm. In some embodiments, the thickness, t, of resistive thin film 111 is not more than 10 nm. In particular, a thickness of about 10 nm may be advantageous to provide a wide range of resistivities while not providing a large topography in integrated circuit structure 100. Such thickness may be measured using any suitable technique or techniques such as a thickness at a single location or as an average of thicknesses at multiple locations.

Furthermore, the width, w, and length, L, of resistive thin film 111 may be varied depending on desired resistance and other performance characteristics. With reference to FIG. 2, in some embodiments, the width, w, of resistive thin film 111 is in the range of 50 to 300 nm. In some embodiments, the width, w, of resistive thin film 111 is in the range of 100 to 200 nm. In some embodiments, the width, w, of resistive thin film 111 is in the range of 150 to 200 nm. In some embodiments, the length, L, of resistive thin film 111 is on the order of microns. In some embodiments, the length, L, of resistive thin film 111 is in the range of 0.5 to 10 microns. In some embodiments, the length, L, of resistive thin film 111 is in the range of 1 to 5 microns. In some embodiments, the length, L, of resistive thin film 111 is in the range of 3 to 10 microns.

As discussed, the material system of resistive thin film 111 is employed to provide a wide range of resistivities of resistive thin film 111. Resistive thin film 111 may include any suitable metal oxide based thin film. In some embodiments, resistive thin film 111 is an alloy including a metal oxide base and a second metal element included in the base. In some embodiments, the metal oxide base is indium oxide. In some embodiments, the metal oxide base is gallium oxide. Other metal oxide bases may be used. Absent the second metal element, the material has a lowest corresponding resistance and incremental addition of the second metal element reduces resistance in the material system. The concentration of the second metal element may be any suitable value such as a concentration in the range of 0.1 to 30%. Notably, the second metal element can be selected and employed to vary the desired resistance and other performance characteristics of thin film resistor 116.

In some embodiments, resistive thin film 111 is an alloy of indium, oxygen, and a second metal element. As discussed, such a material system may be characterized as the following alloy: InₓO_{1-x-y}ME_{y} where ME is used to represent the second metal element. In some embodiments, one or more additional metal elements may also be employed. In some embodiments, the second metal element is any element selected from the alkali metals, alkaline earth metals, transition metals, post-transition metals, lanthanides, and actinides. In some embodiments, the second metal element is one sodium, potassium, rubidium, cesium, beryllium, magnesium, calcium, strontium, barium, radium, scandium, titanium, vanadium, chromium, manganese, iron, cobalt, nickel, copper, zinc, yttrium, zirconium, niobium, molybdenum, ruthenium, rhodium, palladium, silver, cadmium, hafnium, tantalum, tungsten, platinum, gold, gallium, thallium, tin, lead, bismuth. In some embodiments, the second metal element one of aluminum, magnesium, or hafnium with aluminum being particularly advantageous.

The concentration (by percentage) of the second metal element may be any suitable amount. In some embodiments, the concentration of the second metal element is less than 30%. the concentration of the second metal element is not more than 30%. Furthermore, varying the concentration varies the characteristic resistance of resistive thin film 111. In some embodiments, the concentration of the second metal element is in the range of 0.01 to 2%. In some embodiments, the concentration of the second metal element is in the range of 1 to 5%. In some embodiments, the concentration of the second metal element is in the range of 5 to 10%. the concentration of the second metal element is in the range of 10 to 15%. In some embodiments, the concentration of the second metal element is in the range of 15 to 20%. In some embodiments, the concentration of the second metal element is in the range of 20 to 25%. In some embodiments, the concentration of the second metal element is in the range of 25 to 30%. In some embodiments, the concentration of the elements of the base metal oxide (e.g., indium and oxygen) is approximately the same. For example, given y is the concentration of the second metal element (or the total concentration of the second metal elements), the concentration of the metal element of the metal oxide and the oxygen of the metal oxygen may be about that same (e.g., (1-y)/2).

Using the discussed characteristics of resistive thin film 111-width, length, selection of base metal oxide, selection of one or more additional metal elements, and selection of the one or more additional metal element concentrations-a wide range of resistance are attainable. Notably, such variation is advantageously available without varying thickness. Furthermore, even if many or all parameters outside of the concentration of the one or more additional metal element concentration(s) are fixed, a wide range of resistance is still attainable based on varying the concentration of the additional metal element.

For example, given a base metal oxide including indium and oxygen (e.g., an indium oxide alloy), after selection of a second metal element, a 50x or more variation in resistance is attainable based on varying the concentration of the second metal element. In some embodiments, a base metal oxide including indium and oxygen is employed and the second metal element is aluminum such that a material system of InₓO_{1-x-y}Al_{y} is employed for resistive thin film 111. In such contexts, by varying the concentration of aluminum from 0.1% (or less) to 30%, resistance variation of more than 5x is attained without varying thickness. In some embodiments, resistive thin film 111 includes indium, oxygen, and aluminum with the aluminum concentration being in the range of 0.1 to 30% of resistive thin film 111. In some embodiments, resistive thin film 111 includes indium, oxygen, and aluminum with the aluminum concentration being in the range of 5 to 30% of resistive thin film 111. In some embodiments, resistive thin film 111 includes indium, oxygen, and aluminum with the aluminum concentration being in the range of 5 to 10% of resistive thin film 111. In some embodiments, resistive thin film 111 includes indium, oxygen, and aluminum with the aluminum concentration being in the range of 10 to 20% of resistive thin film 111. In some embodiments, resistive thin film 111 includes indium, oxygen, and aluminum with the aluminum concentration being in the range of 20 to 30% of resistive thin film 111.

Discussion now turns to the deployment of any number of thin film resistors 116, each at the same material level (e.g., the same level within metallization levels 102) with other thin film resistors at one or more differing material levels within integrated circuit structure 100.

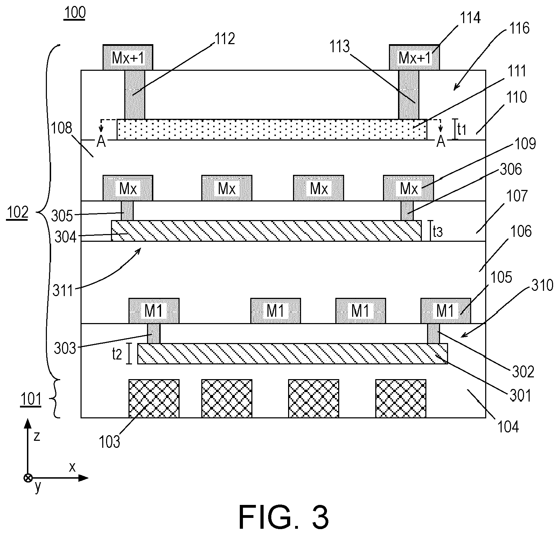

FIG. 3 is a cross-sectional view of integrated circuit structure 100 including thin film resistor 116 and one or more additional thin film resistors at different levels within integrated circuit structure 100, arranged in accordance with at least some implementations of the present disclosure. As shown in both FIGS. 1 and 3, thin film resistor 116 may be located between metallization level 114 (e.g., metal x+1, Mx+1) and metallization level 109 (e.g., metal x, Mx) and coupled to metallization level 114. However, thin film resistor 116 may be located anywhere within metallization levels 102. For example, thin film resistor 116 may be between any of metallization levels 102 or thin film resistor 116 may be between metallization level 105 (e.g., metal 1, M1) and device layer 101. It is noted that, as used herein, the term immediately between respect to levels or the like indicates no intervening levels are therebetween. For example, a resistor is immediately between device layer 101 and metallization level 105 if no other device layer(s) or metallization level(s) intervene between the resistor and the pertinent layer or level, although other materials or structures (e.g., dielectric or vias) may intervene.

As shown in FIG. 3, integrated circuit structure 100 also includes one or both of a thin film resistor 310 and a thin film resistor 311. Thin film resistor 310 includes electrodes 302, 303 and a resistive thin film 301 (or thin film element) and thin film resistor 311 includes electrodes 305, 306 and a resistive thin film 304 (or thin film element). Electrodes 302, 303, 305, 306 may have any characteristics discussed herein with respect to electrodes 112, 113. Furthermore, resistive thin films 301, 304 may have any characteristics discussed herein with respect to resistive thin film 111. In some embodiments, thin film resistor 310 and thin film resistor 311 have lower sheet resistance values relative to thin film resistor 116.

In some embodiments, resistive thin films 301, 304 employ the same material system as resistive thin film 111 (i.e., the same base metal oxide and the same second metal element) with the same or differing characteristics. For example, one or both of resistive thin films 301, 304 may have the same thickness with respect to resistive thin film 111 (i.e., t1=t2=t3), the same second metal element concentration, and the same length and/or width (not shown). Alternatively, resistive thin films 301, 304 may differing characteristics. In some embodiments, the thickness increases with increasing metallization level (i.e., t2<t3<t1). In some embodiments, the concentration of the second metal element increases with increasing metallization level such that a concentration of the second metal element in resistive thin film 301 is less than a concentration of the second metal element in resistive thin film 304, which is in turn, less than a concentration of the second metal element in resistive thin film 111. It is noted that such variation may provide improved design characteristics for integrated circuit structure 100.

Alternatively, one or both of resistive thin films 301, 304 may employ a differing material system with respect to resistive thin film 111. For example, the discussed material systems for resistive thin film 111 may be advantageous for back end thin film resistors while being disadvantageous for other thin film resistors and, in particular, thin film resistor 310. Notably, it may be undesirable for the materials used in resistive thin film 111 to be near transistors 103 as those materials may migrate from resistive thin film 301 to transistors 103 and negatively impact their performance and, in extreme cases, cause them to be non-functional.

In some embodiments, one or both of resistive thin films 301, 304 (and, in particular resistive thin film 301) employs a metallic thin film material. In some embodiments, the metallic thin film is titanium nitride such that resistive thin film 301 includes titanium and nitrogen. In some embodiments, thin film is tungsten. In some embodiments, thin film is tantalum nitride such that resistive thin film 301 includes tantalum and nitrogen. Combinations of such materials may also be used. It is further noted that any of resistive thin films 111, 301, 304 may include or be bounded by a barrier layer to reduce migration, improve adhesion, etc.

As shown in both FIGS. 1 and 3, in some embodiments, metallization levels 102 include at least three metallization levels 105, 109, 114 and thin film resistor 116 is above at least two metallization levels including metallization levels 105, 109. Thin film resistor 116 may be above any number of metallization levels such as 4, 5, 6 or more metallization levels. Furthermore, although illustrated as being below at least one metallization level 114, thin film resistor 116 may be below two or more levels or thin film resistor 116 may be above a final metallization level.

As shown in FIG. 3, in some embodiments, thin film resistor 310 is below a first metallization level 105 (i.e., with first, second, third, etc. being defined in an order extending from transistors 103 in the z-direction) and immediately between metallization level 105 and device layer 101 such that no additional metallization levels are between metallization level 105 and device layer 101. In some embodiments, in such configurations, thin film resistor 310 employs a metallic thin film (e.g., titanium nitride, tungsten, or tantalum nitride) absent the indium oxide plus additional metal element based material systems discussed herein. Additionally, both thin film resistor 311 and thin film resistor 116 are above metallization level 105. Thin film resistor 311 may be immediately above metallization level 105 (e.g., between first and second metallization levels) or above any of the first, second, third, and so on metallization levels. Thin film resistor 116 is immediately above metallization level 109 and immediately below metallization level 114. In some embodiments, metallization level 109 is a second to last metallization level and metallization level 114 is a last metallization level (e.g., prior to passivation, bond pad, etc.) of integrated circuit structure 100.

Integrated circuit structure 100 may be employed in any suitable device package, platform, etc. for any purpose. In some embodiments, integrated circuit structure 100 is part of an analog integrated circuit. For example, the resistors and resistor systems discussed herein may be advantageously employed in voltage regulator circuits or radio frequency (RF) circuits, although the resistors and resistor systems may be employed in any suitable context. In some embodiments, a system or device (e.g., a computing system or electronic device) includes a power supply and integrated circuit structure 100. Such systems are discussed further herein below. Notably, integrated circuit structure 100 may be employed in any suitable component of a system or device discussed herein. As discussed, in some embodiments, integrated circuit structure 100 includes any number of transistors 103 within device layer 101, any number of resistors 116 including resistive thin film 111 such that resistive thin film 111 includes indium, oxygen, and a second metal element, and any number of resistors 310, 311 including resistive thin films 301, 304, respectively. Resistive thin films 301, 304 may include the same or similar material system as resistive thin film 111 or they may be different. Notably, resistive thin films 111, 301, 304 may include any material characteristics discussed herein with respect to any resistive thin film.

Discussion now turns to methods for forming thin film resistors having a base metal oxide material and an additional metal element. Such techniques are illustrated with respect to forming thin film resistor 116. However, the discussed techniques may be used to form any or all of thin film resistors 116, 310, 311.

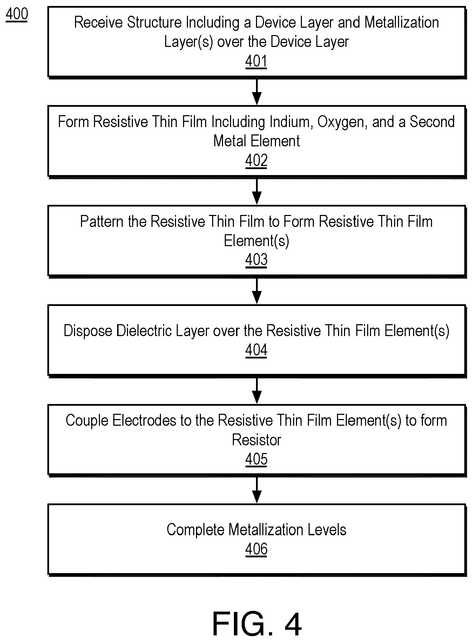

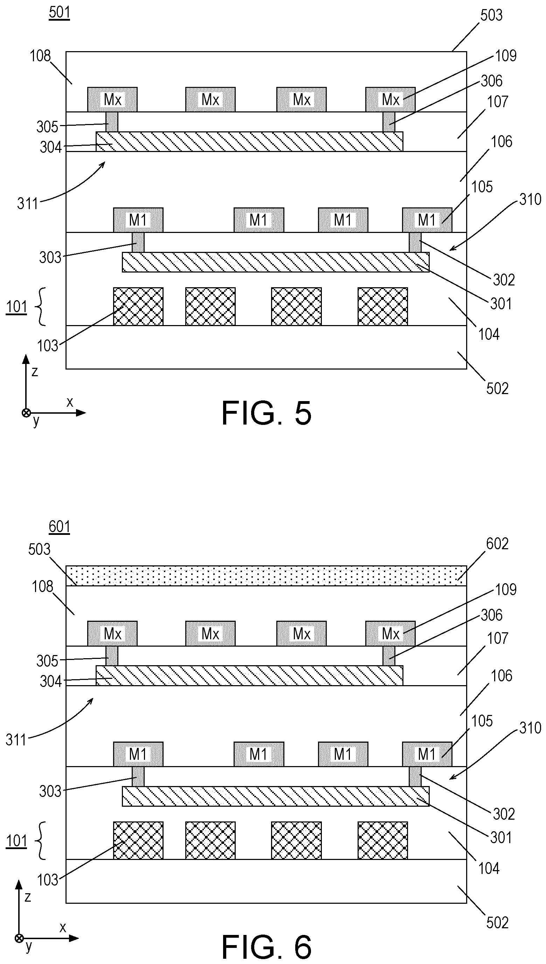

FIG. 4 is a flow diagram illustrating methods 400 for forming integrated circuit structures with thin film resistors, arranged in accordance with at least some implementations of the present disclosure. FIGS. 5, 6, 7, 8, 9, 10, 11, and 12 are cross-sectional views of exemplary integrated circuit structures as selected fabrication operations in methods 400 are performed, arranged in accordance with at least some implementations of the present disclosure.

As shown in FIG. 4, methods 400 begin at operation 401, where a structure is received for processing. The received structure is a partially fabricated structure that may be formed on a substrate wafer. A device layer is formed within, on, and/or over the substrate wafer. The device layer may include any devices discussed herein such as transistors, memory devices, capacitors, resistors, optoelectronic devices, switches, or any other active or passive electronic devices. The received structure may further include one or more metallization layers over the device layer. In some embodiments, no metallization layers are formed over the device layer. Such devices and metallization layer(s) may be formed using any suitable technique or techniques known in the art.

FIG. 5 illustrates an example integrated circuit structure 501 including transistors 103 within, on, and/or over a substrate 502. Substrate 502 may include any suitable material or materials for the formation of transistors 103 inclusive of a semiconductor material such as monocrystalline silicon, germanium, silicon germanium, a III-V materials based material (e.g., gallium arsenide), a silicon carbide, a sapphire, or any combination thereof. As discussed, although illustrated with respect to transistors 103, device layer 101 may include transistors, memory devices, capacitors, resistors, optoelectronic devices, switches, or any other active or passive electronic devices.

Integrated circuit structure 501 further includes metallization levels inclusive of metallization level 105, metallization level 109, and any intervening metallization level(s). As discussed, each of such metallization levels includes any number of conductive traces or features to provide routing circuitry and other uses. Integrated circuit structure 501 also includes thin film resistors 310, 311, which may have any characteristics discussed herein. Furthermore, thin film resistors 310, 311 may be generated using methods 400. In some embodiments, thin film resistors 310, 311 include the material systems discussed with respect to methods 400. In other embodiments, other material systems as discussed herein are employed. In such embodiments, methods 400 may be modified with respect to operation 402 to form the appropriate material(s) for thin film resistors 310, 311. Although illustrated with respect to integrated circuit structure 501 including thin film resistors 310, 311, in some embodiments one or both of thin film resistors 310, 311 are absent.

Such metallization levels and resistors are within dielectric material layers or dielectric materials inclusive of dielectric layers 104, 106, 107, 108. Such dielectric layers 104, 106, 107, 108 may include any suitable dielectric materials such as alumina, silica, silicon nitrides, silicon oxynitrides, silicon carbonitride, or combinations thereof. Such dielectric layers 104, 106, 107, 108 and metallization layers may be formed using any suitable technique or techniques such dual damascene techniques, deposition and patterning techniques, or the like. Notably, in the illustrated embodiment, integrated circuit structure 501 has dielectric layer 108 at a top surface 503 thereof such that the subsequent thin film resistive element may be formed on a dielectric layer that provides electric isolation from other conductive features of integrated circuit structure 501. In such embodiments, coupling to the thin film resistive element is subsequently made from the top of the thin film resistive element. In other embodiments, one or more metal features (e.g., vias) may be provided at top surface 503 of integrated circuit structure 501 such that the thin film resistive element is formed on the metal features and electrical coupling is provided thereby.

Returning to FIG. 4, methods 400 at operation 402, where a resistive thin film is formed such that the resistive thin film includes a metal oxide base material and a second metal element. Although illustrated with respect to indium, oxygen, and a second metal element (e.g., an indium oxide base with a second metal element: InₓO_{1-x-y}ME_{y}), any base metal and oxygen with second metal element material discussed herein may be employed. Furthermore, the second metal element may be any second metal element discussed herein. In some embodiments, the second metal element is aluminum. In some embodiments, the second metal element is magnesium. In some embodiments, the second metal element is aluminum is hafnium. In some embodiments, multiple second metal elements are employed. In some embodiments, the resistive thin film includes indium, oxygen, aluminum, and magnesium. In some embodiments, the resistive thin film includes indium, oxygen, aluminum, and hafnium. In some embodiments, the resistive thin film includes indium, oxygen, magnesium, and hafnium. Other combinations are available based on the materials discussed herein.

The resistive thin film may be formed using any suitable technique or techniques such as deposition techniques including chemical vapor deposition (CVD), atomic layer deposition (ALD), or physical vapor deposition (PVD). In some embodiments, the resistive thin film is formed by PVD with co-sputtering using two targets: a first target including the base metal element and oxygen and a second target including the second metal element and oxygen. Such techniques provide in situ inclusion of the base metal and the second metal with control over the concentration of the second metal in the resistive thin film. The base metal may be any materials discussed herein such as indium. The second metal element may also be any second metal element discussed herein such as aluminum, magnesium, or hafnium. In some embodiments, the PVD co-sputtering employs a first target including indium and oxygen and a second target including one of aluminum, magnesium, or hafnium and oxygen. In contexts where the second metal is aluminum, the PVD co-sputtering employs a target including indium and oxygen and another target including aluminum and oxygen.

Notably, the resistive thin film provides an oxide based thin film capable of modulating resistance thru in-situ doping to change the resistance value of the film from low resistance to high resistance depending on the concentration of the second metal element. The resistive thin film is thermally stable up to 400°C across the different doping concentrations needed to vary the resistance (e.g., from 0.1% to 30% second metal element). In some embodiments, a resistive thin film deposited at 300°C at a thickness of not less than 3 nm shows no structure change after processing at 400°C. Therefore, the resistive thin film provides a wide range of sheet resistivity values within the thermal budget needed for employment in an integrated circuit structure. Furthermore, in-situ doping provides uniform doping distribution in the oxide based thin film resistor and resistance variation due to composition difference is eliminated. That is, the factor affecting resistance variation in the resultant thin film resistor is mainly from dimension of thin film resistor itself. Further still, the oxide based thin film resistor formation techniques discussed herein provide low thickness and pattern variation such that resistance variation is again small.

FIG. 6 illustrates an example integrated circuit structure 601, similar to integrated circuit structure 501, after the formation of resistive thin film 602. As shown, resistive thin film 602 is formed substantially conformally over top surface 503. Resistive thin film 602 may include any material system and composition discussed herein. Furthermore, resistive thin film 602 may have any thickness discussed herein with respect to resistive thin film 111. For example, the thickness of resistive thin film 602 may be in the range of 5 to 15 nm, in the range of 5 to 10 nm, in the range of 6 to 8 nm, or not more than 10 nm. In some embodiments, the thickness of resistive thin film 602 is in the range of 8 to 12 nm. As discussed, by varying the composition of resistive thin film 602 and, in particular, the concentration of the second metal element, differing resistances may be provided without substantially altering the thickness of resistive thin film 602. Such techniques are advantageous as changes in sheet resistance may be deployed without altering the thickness and corresponding process changes to for the resultant integrated circuit structure.

Returning to FIG. 4, methods 400 at operation 403, where the resistive thin film is patterned to form any number and shapes of resistive thin film elements. For example, although illustrated with respect to substantially rectangular (i.e., in cross section in the x-y plane) resistive thin film element, any shape may be employed. In particular, such resistive thin film elements may be routed among other circuitry of the integrated circuit structure. The resistive thin film may be patterned using any suitable technique or techniques such as lithography and etch techniques (e.g., subtractive patterning).

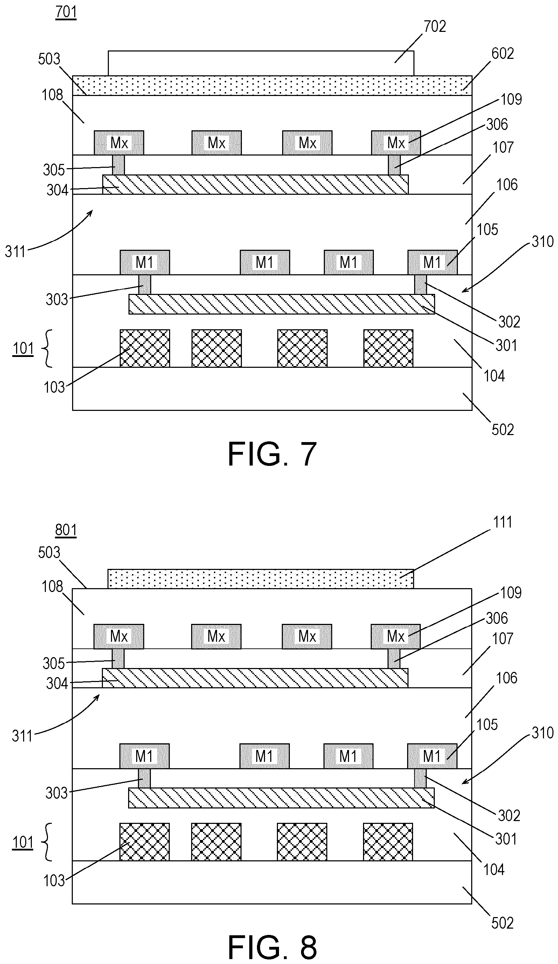

FIG. 7 illustrates an example integrated circuit structure 701, similar to integrated circuit structure 601, after the formation of a patterned resist layer 702. As shown, patterned resist layer 702 is formed on resistive thin film 602 and includes a pattern that matches the desired shape for a resultant resistive thin film element. Patterned resist layer 702 is formed using any suitable technique or techniques such as lithography techniques. FIG. 8 illustrates an example integrated circuit structure 801, similar to integrated circuit structure 701, after the formation of resistive thin film 111 (e.g., including any number and shape of resistive thin film elements). Resistive thin film 111 may have any characteristics discussed herein with respect to FIGS. 1 and 3 and elsewhere herein. In particular, resistive thin film 111 may have a width in the range of 50 to 300 nm, in the range of 100 to 200 nm, in the range of 150 to 200 nm, or the like and a length in the range of 0.5 to 10 microns, in the range of 1 to 5 microns, in the range of 3 to 10 microns, or the like.

Returning to FIG. 4, methods 400 at operation 404, where a dielectric layer is formed over the resistive thin film element. The dielectric layer is to provide electric isolation for the resistive thin film element and the dielectric layer may be formed using any suitable technique or techniques. For example, operation 404 may include a dielectric deposition process. In an embodiment, a flowable oxide deposition (plasma-enhanced chemical vapor deposition (PECVD)) process may be employed to form the insulating dielectric (e.g., Al₂O₃, SiO SiN, SiON, SiCN SiO2, SiOCN, SiOC(H)), although other deposition techniques such as spin on techniques maybe used. In some embodiments, formation of the dielectric layer may also include a planarization operation after the deposition.

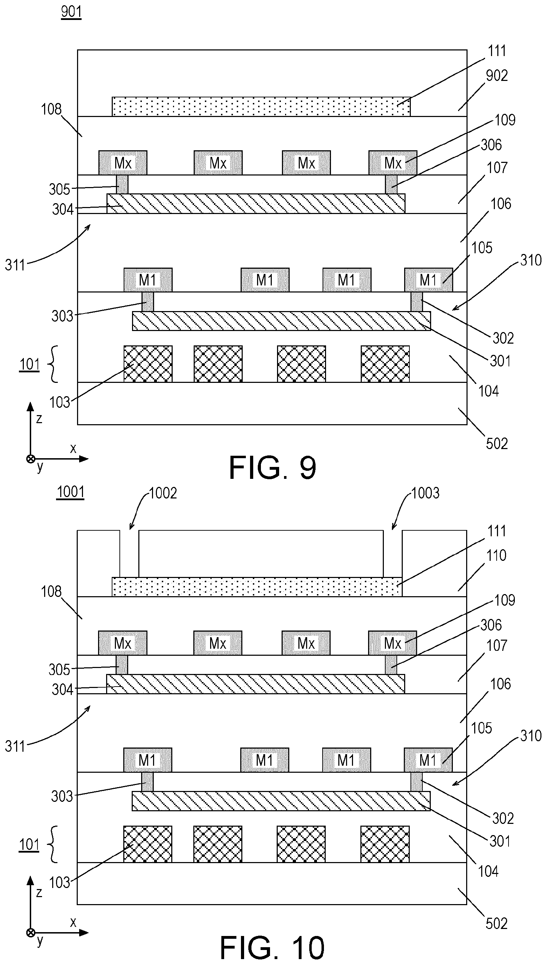

FIG. 9 illustrates an example integrated circuit structure 901, similar to integrated circuit structure 801, after the formation of a dielectric layer 902 over resistive thin film 111. As shown, dielectric layer 902 is over and on resistive thin film 111 and provides electrical isolation for resistive thin film 111.

Returning to FIG. 4, methods 400 at operation 405, where electrodes are coupled to the resistive thin film element to form a resistor. The electrodes may be coupled to the resistive thin film element using any suitable technique or techniques. In some embodiments, the dielectric layer formed at operation 404 is patterned to form openings to the resistive thin film element and the openings are filled to form the electrodes as illustrated herein below. In other embodiments, the electrodes were previously formed and the resistive thin film element is formed on the electrodes. For example, top surface 503 may include electrodes (please refer to FIGS. 5 to 8) and the resistive thin film element may be coupled to the electrodes by forming resistive thin film 602 and patterning it to provide resistive thin film 111 in contact with the previously formed electrodes. For example, resistive thin film 111 may be above or below the electrodes.

FIG. 10 illustrates an example integrated circuit structure 1001, similar to integrated circuit structure 901, after the formation of openings 1002, 1003 in dielectric layer 902 to provide dielectric layer 110 (e.g., a patterned dielectric layer). As shown, openings 1002, 1003 provide a pattern for landing electrodes on resistive thin film 111. Openings 1002, 1003 may be formed using any suitable technique or techniques such as lithography and etch techniques. In some embodiments, a resist pattern is formed on dielectric layer 902 such that the resist pattern has openings that correspond to openings 1002, 1003, the exposed portions of dielectric layer 902 are etched to form openings 1002, 1003, and the resist pattern is removed (e.g., via ashing).

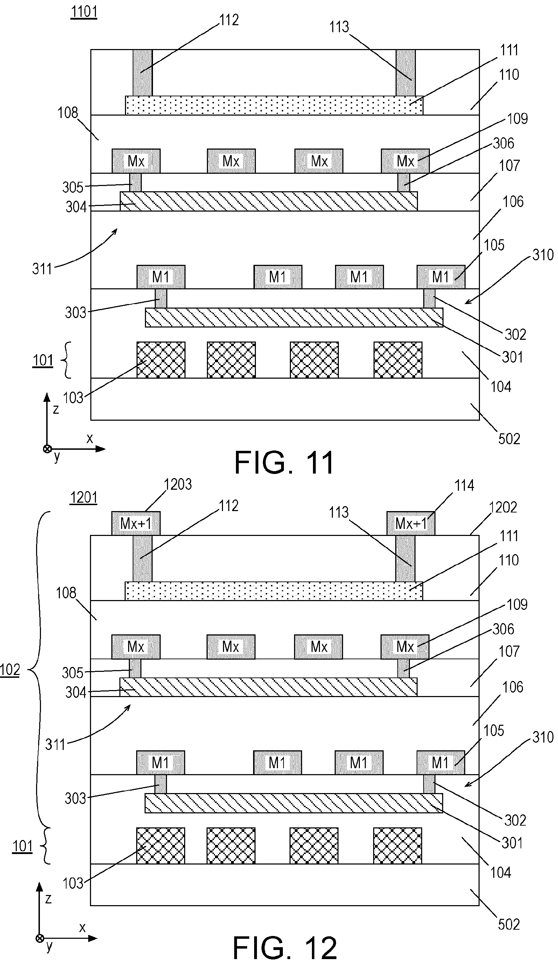

FIG. 11 illustrates an example integrated circuit structure 1101, similar to integrated circuit structure 1001, after the formation of electrodes 112, 113 within openings 1002, 1003. Electrodes 112, 113 may include any characteristics discussed elsewhere herein. In some embodiments, electrodes 112, 113 are formed by plating a metal (e.g., copper) and planarization to remove excess metal formed on and over dielectric layer 110. Although illustrated with respect to forming openings 1002, 1003 and filling the openings with electrodes 112, 113, other techniques may be used such as depositing the bulk material of electrodes 112, 113, patterning to provide electrodes 112, 113, depositing the bulk material of dielectric layer 110, and planarization to form integrated circuit structure 1101. Furthermore, in some embodiments, metallization level 114 is formed with electrodes 112, 113 using dual damascene techniques.

Returning to FIG. 4, methods 400 at operation 406, where remaining metallization levels are formed to complete the metallization levels of the integrated circuit structure. In some embodiments, operation 406 includes formation of a single metallization level that is coupled to the thin film resistor formed with respect to operations 401-405 (and to lower metallization levels). Furthermore, as discussed, the thin film resistor formed with respect to operations 401-405 may be within any level of the metallization level and operation 406. In some embodiments, operation 406 includes forming additional metallization levels (and corresponding via levels) above the thin film resistor.

FIG. 12 illustrates an example integrated circuit structure 1201, similar to integrated circuit structure 1101, after the formation of metallization level 114. Metallization level 114 may be formed using any suitable technique or techniques. In some embodiments, the bulk material of metallization level 114 is formed on a top surface 1202 of integrated circuit structure 1201 and the bulk material is patterned using subtractive lithography to form metallization level 114. In some embodiments, metallization level 114 is formed with electrodes 112, 113 (and other optional vias to a lower metallization level) using dual damascene techniques. In such embodiments, integrated circuit structure 1201 may also include a dielectric layer adjacent to metallization level 114 and having a top surface substantially aligned with a top surface 1203 of metallization level 114.

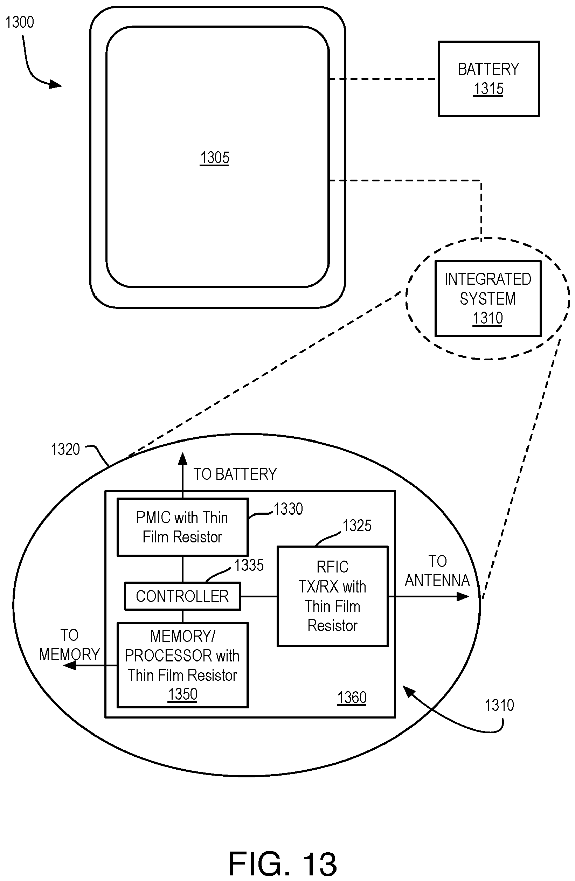

FIG. 13 is an illustrative diagram of a mobile computing platform 1300 employing a device having a thin film resistor, arranged in accordance with at least some implementations of the present disclosure. Any die or device having a thin film resistor such as thin film resistor 116 inclusive of any characteristics discussed herein may be implemented by any component of mobile computing platform 1300. Mobile computing platform 1300 may be any portable device configured for each of electronic data display, electronic data processing, wireless electronic data transmission, or the like. For example, mobile computing platform 1300 may be any of a tablet, a smart phone, a netbook, a laptop computer, etc. and may include a display screen 1305, which in the exemplary embodiment is a touchscreen (e.g., capacitive, inductive, resistive, etc. touchscreen), a chip-level (SoC) or package-level integrated system 1310, and a battery 1315. Battery 1315 may include any suitable device for providing electrical power such as a device consisting of one or more electrochemical cells and electrodes to couple to an outside device. Mobile computing platform 1300 may further include a power supply to convert a source power from a source voltage to one or more voltages employed by other devices of mobile computing platform 1300.

Integrated system 1310 is further illustrated in the expanded view 1320. In the exemplary embodiment, packaged device 1350 (labeled "Memory/Processor" in FIG. 13) includes at least one memory chip (e.g., RAM), and/or at least one processor chip (e.g., a microprocessor, a multi-core microprocessor, or graphics processor, or the like). In an embodiment, the package device 1350 is a microprocessor including an SRAM cache memory. As shown, device 1350 may employ a die or device having any thin film resistor structures and/or related characteristics discussed herein. Packaged device 1350 may be further coupled to (e.g., communicatively coupled to) a board, a substrate, or an interposer 1360 along with, one or more of a power management integrated circuit (PMIC) 1330, RF (wireless) integrated circuit (RFIC) 1325 including a wideband RF (wireless) transmitter and/or receiver (TX/RX) (e.g., including a digital baseband and an analog front end module further comprises a power amplifier on a transmit path and a low noise amplifier on a receive path), and a controller 1335 thereof. In general, packaged device 1350 may be also be coupled to (e.g., communicatively coupled to) display screen 1305. As shown, one or both of PMIC 1330 and RFIC 1325 may employ a die or device having any thin film resistor structures and/or related characteristics discussed herein.

Functionally, PMIC 1330 may perform battery power regulation, DC-to-DC conversion, etc., and so has an input coupled to battery 1315 and with an output providing a current supply to other functional modules. In an embodiment, PMIC 1330 may perform high voltage operations. As further illustrated, in the exemplary embodiment, RFIC 1325 has an output coupled to an antenna (not shown) to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. In alternative implementations, each of these board-level modules may be integrated onto separate ICs coupled to the package substrate of packaged device 1350 or within a single IC (SoC) coupled to the package substrate of the packaged device 1350.

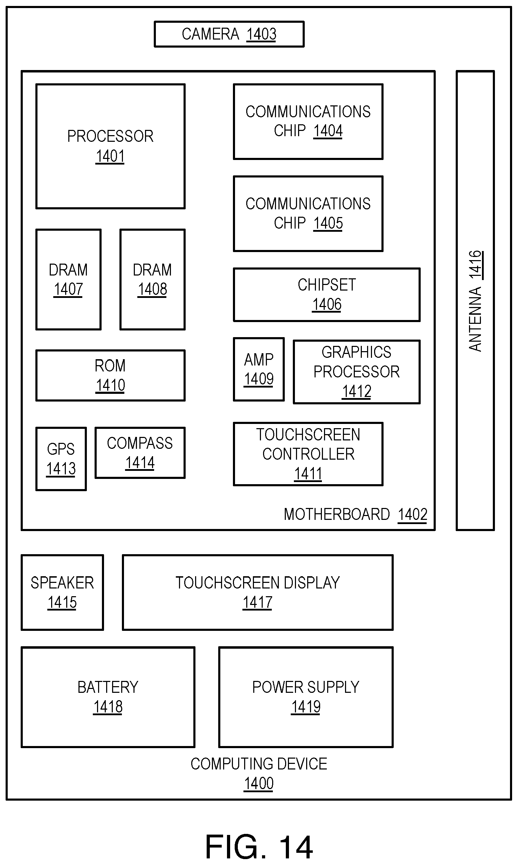

FIG. 14 is a functional block diagram of a computing device 1400, arranged in accordance with at least some implementations of the present disclosure. Computing device 1400 may be found inside platform 1300, for example, and further includes a motherboard 1402 hosting a number of components, such as but not limited to a processor 1401 (e.g., an applications processor) and one or more communications chips 1404, 1405. Processor 1401 may be physically and/or electrically coupled to motherboard 1402. In some examples, processor 1401 includes an integrated circuit die packaged within the processor 1401. In general, the term "processor" may refer to any device or portion of a device that processes electronic data from registers and/or memory to transform that electronic data into other electronic data that may be stored in registers and/or memory. Any one or more device or component of computing device 1400 may include a die or device having any thin film resistor structures and/or related characteristics discussed herein as discussed herein.

In various examples, one or more communication chips 1404, 1405 may also be physically and/or electrically coupled to the motherboard 1402. In further implementations, communication chips 1404 may be part of processor 1401. Depending on its applications, computing device 1400 may include other components that may or may not be physically and electrically coupled to motherboard 1402. These other components may include, but are not limited to, volatile memory (e.g., DRAM) 1407, 1408, non-volatile memory (e.g., ROM) 1410, a graphics processor 1412, flash memory, global positioning system (GPS) device 1413, compass 1414, a chipset 1406, an antenna 1416, a power amplifier 1409, a touchscreen controller 1411, a touchscreen display 1417, a speaker 1415, a camera 1403, a battery 1418, and a power supply 1419, as illustrated, and other components such as a digital signal processor, a crypto processor, an audio codec, a video codec, an accelerometer, a gyroscope, and a mass storage device (such as hard disk drive, solid state drive (SSD), compact disk (CD), digital versatile disk (DVD), and so forth), or the like.

Communication chips 1404, 1405 may enable wireless communications for the transfer of data to and from the computing device 1400. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. Communication chips 1404, 1405 may implement any of a number of wireless standards or protocols, including but not limited to those described elsewhere herein. As discussed, computing device 1400 may include a plurality of communication chips 1404, 1405. For example, a first communication chip may be dedicated to shorter range wireless communications such as Wi-Fi and Bluetooth and a second communication chip may be dedicated to longer range wireless communications such as GPS, EDGE, GPRS, CDMA, WiMAX, LTE, Ev-DO, and others. Furthermore, power supply 1419 may convert a source power from a source voltage to one or more voltages employed by other devices of mobile computing platform 1300. In some embodiments, power supply 1419 converts an AC power to DC power. In some embodiments, power supply 1419 converts an DC power to DC power at one or more different (lower) voltages. In some embodiments, multiple power supplies are staged to convert from AC to DC and then from DC at a higher voltage to DC at a lower voltage as specified by components of computing device 1400.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

In one or more first embodiments, an integrated circuit structure comprises a plurality of transistors within a device layer, one or more levels of metallization coupled to at least one of the transistors, and a resistor comprising first and second electrodes and a resistive thin film coupled to the first and second electrodes, the resistive thin film comprising indium, oxygen, and a second metal element.

In one or more second embodiments, further to the first embodiments, the second metal element comprises one of aluminum, magnesium, or hafnium.

In one or more third embodiments, further to the first or second embodiments, the second metal element has a concentration of not more than 30% of the resistive thin film.

In one or more fourth embodiments, further to any of the first through third embodiments, the one or more levels of metallization comprise at least first, second and third levels of metallization in turn above the transistors, and wherein the resistor is above at least the second level of metallization.

In one or more fifth embodiments, further to any of the first through fourth embodiments, the integrated circuit structure further comprises a second resistor comprising a second resistive thin film comprising a metallic film, wherein the second resistor is below a fist metallization level of the one or more levels of metallization and the resistor is above the fist metallization level.

In one or more sixth embodiments, further to any of the first through fifth embodiments, the metallic film comprises one of titanium nitride, tungsten, or tantalum nitride.

In one or more seventh embodiments, further to any of the first through sixth embodiments, the second resistor is immediately between the first metallization level and the transistors and the resistor is above a second metallization level that is over the first metallization level.

In one or more eighth embodiments, further to any of the first through seventh embodiments, the second metal element comprises aluminum and the metallic film comprises titanium nitride.

In one or more ninth embodiments, further to any of the first through eighth embodiments, the aluminum has a concentration in the range of 5 to 30% of the resistive thin film.

In one or more tenth embodiments, further to any of the first through ninth embodiments, the resistive thin film has a thickness in the range of 5 to 10 nm, a width in the range of 100 to 200 nm, and a length in the range of 0.5 to 10 microns.

In one or more eleventh embodiments, a system comprises a power supply and an integrated circuit structure according to any of the first through tenth embodiments coupled to the power supply.

In one or more twelfth embodiments, a system comprises a power supply and an analog integrated circuit structure coupled to the power supply, the analog integrated circuit structure comprising a plurality of transistors within a device layer, a plurality of first resistors comprising a first resistive thin film, and a plurality of second resistors comprising a second resistive thin film, the first resistive thin film comprising indium, oxygen, and a second metal element.

In one or more thirteenth embodiments, further to the twelfth embodiments, the analog integrated circuit structure further comprises a plurality of metallization levels over the device layer, wherein the plurality of second resistors are between a first metallization level of the plurality of metallization levels and the device layer and the plurality of first resistors are between the first metallization level and a second metallization level of the plurality of metallization levels.

In one or more fourteenth embodiments, further to the twelfth or thirteenth embodiments, the second metal element comprises one of aluminum, magnesium, or hafnium at a concentration of not more than 30% of the first resistive thin film

In one or more fifteenth embodiments, further to any of the twelfth through fourteenth embodiments, the second resistive thin film comprises one of titanium nitride, tungsten, or tantalum nitride.

In one or more sixteenth embodiments, further to any of the twelfth through fifteenth embodiments, the second metal element comprises aluminum having a concentration in the range of 5 to 30% of the first resistive thin film.

In one or more seventeenth embodiments, further to any of the twelfth through sixteenth embodiments, the second resistive thin film comprises titanium and nitrogen.

In one or more eighteenth embodiments, a method of forming an integrated circuit structure comprises forming a resistive thin film over a first dielectric layer, wherein the first dielectric layer is over a plurality of metallization levels and a device layer, the resistive thin film comprising indium, oxygen, and a second metal element, patterning the resistive thin film to form one or more resistive thin film elements, disposing a second dielectric layer over the resistive thin film elements, and coupling at least one of the resistive thin film elements to corresponding first and second electrodes.

In one or more nineteenth embodiments, further to the eighteenth embodiments, the plurality of metallization levels are over a second thin film resistive element that is immediately adjacent to the device layer, wherein the second thin film resistive element comprises one of titanium nitride, tungsten, or tantalum nitride and the resistive thin film comprises one of aluminum, magnesium, or hafnium at a concentration of not more than 30% of the resistive thin film.

In one or more twentieth embodiments, further to the eighteenth or nineteenth embodiments, forming the resistive thin film comprises a physical vapor deposition with co-sputtering using a first target comprising indium and oxygen and a second target comprising aluminum and oxygen.

In one or more twenty-first embodiments, further to any of the eighteenth through twentieth embodiments, coupling at coupling at least one of the resistive thin film elements to corresponding first and second electrodes comprises forming via openings in the second dielectric layer and forming the first and second electrodes in the via openings.

It will be recognized that the invention is not limited to the embodiments so described, but can be practiced with modification and alteration without departing from the scope of the appended claims. For example, the above embodiments may include specific combination of features. However, the above embodiments are not limited in this regard and, in various implementations, the above embodiments may include the undertaking only a subset of such features, undertaking a different order of such features, undertaking a different combination of such features, and/or undertaking additional features than those features explicitly listed. The scope of the invention should, therefore, be determined with reference to the appended claims, along with the full scope of equivalents to which such claims are entitled.

## Claims

1. An integrated circuit structure comprising
a plurality of transistors within a device layer;
one or more levels of metallization coupled to at least one of the transistors; and
a resistor comprising first and second electrodes and a resistive thin film coupled to the first and second electrodes, the resistive thin film comprising indium, oxygen, and a second metal element.

2. The integrated circuit structure of claim 1, wherein the second metal element comprises one of aluminum, magnesium, or hafnium.

3. The integrated circuit structure of claim 1, wherein the second metal element has a concentration of not more than 30% of the resistive thin film.

4. The integrated circuit structure of any of claims 1 to 3, wherein the one or more levels of metallization comprise at least first, second and third levels of metallization in turn above the transistors, and wherein the resistor is above at least the second level of metallization.

5. The integrated circuit structure of any of claims 1 to 3, further comprising:
a second resistor comprising a second resistive thin film comprising a metallic film, wherein the second resistor is below a first metallization level of the one or more levels of metallization and the resistor is above the first metallization level.

6. The integrated circuit structure of claim 5, wherein the metallic film comprises one of titanium nitride, tungsten, or tantalum nitride.

7. The integrated circuit structure of claim 5, wherein the second resistor is immediately between the first metallization level and the transistors and the resistor is above a second metallization level that is over the first metallization level.

8. The integrated circuit structure of claim 7, wherein the second metal element comprises aluminum and the metallic film comprises titanium nitride.

9. The integrated circuit structure of claim 8, wherein the aluminum has a concentration in the range of 5 to 30% of the resistive thin film.

10. The integrated circuit structure of any of claims 1 to 3, wherein the resistive thin film has a thickness in the range of 5 to 10 nm, a width in the range of 100 to 200 nm, and a length in the range of 0.5 to 10 microns.

11. A system comprising
a power supply; and
an analog circuit coupled to the power supply, the analog circuit comprising the integrated circuit structure of any of claims 1 to 10.

12. A method of forming an integrated circuit structure comprising:
forming a resistive thin film over a first dielectric layer, wherein the first dielectric layer is over a plurality of metallization levels and a device layer, the resistive thin film comprising indium, oxygen, and a second metal element;
patterning the resistive thin film to form one or more resistive thin film elements;
disposing a second dielectric layer over the resistive thin film elements; and
coupling at least one of the resistive thin film elements to corresponding first and second electrodes.

13. The method of claim 12, wherein the plurality of metallization levels are over a second thin film resistive element that is immediately adjacent to the device layer, wherein the second thin film resistive element comprises one of titanium nitride, tungsten, or tantalum nitride and the resistive thin film comprises one of aluminum, magnesium, or hafnium at a concentration of not more than 30% of the resistive thin film.

14. The method of claim 12 or 13, wherein forming the resistive thin film comprises a physical vapor deposition with co-sputtering using a first target comprising indium and oxygen and a second target comprising aluminum and oxygen.

15. The method of claim 12 or 13, wherein coupling at coupling at least one of the resistive thin film elements to corresponding first and second electrodes comprises forming via openings in the second dielectric layer and forming the first and second electrodes in the via openings.
